# EUROPEAN PATENT SPECIFICATION

(11) **EP 1 668 700 B1**
(45) Date of publication and mention of the grant of the patent: **10.03.2010**
(21) Application number: 03770627.2
(22) Date of filing: 02.10.2003
(51) Int. Cl.: H01L 27/146, G01J 5/22, H01L 31/18

(54) **FABRICATION OF THERMAL DETECTING STRUCTURES**
VERFAHREN ZUR HERSTELLUNG THERMISCHER DETEKTORSTRUKTUREN
PROCEDE DE FABRICATION DE STRUCTURES DE DETECTION THERMIQUE

(43) Date of publication of application: 14.06.2006
(73) Proprietor: Honeywell International Inc., Morristown, NJ 07962-2245 (US)
(72) Inventor: COLE, Barrett, E., Bloomington, MN 55431 (US)
(74) Representative: Clarke, Lionel Paul
(86) International application number: PCT/US2003/031337
(87) International publication number: WO 2005/043624

(56) References cited:
- US-A- 6 130 109
- US-A- 6 144 285
- US-B1- 6 323 486
- REINTSEMA C D ET AL: "Improved VO/sub 2/ microbolometers for infrared imaging: operation on the semiconducting-metallic phase transition with negative electrothermal feedback" PROC. SPIE - INT. SOC. OPT. ENG. (USA), PROCEEDINGS OF THE SPIE - THE INTERNATIONAL SOCIETY FOR OPTICAL ENGINEERING, 1999, SPIE-INT. SOC. OPT. ENG, USA, vol. 3698, April 1999 (1999-04), pages 190-200, XP002292805 ISSN: 0277-786X

## Description

### Background of the Invention

The present invention relates generally to the fabrication of thermal, e.g., infrared (IR), detecting structures. More particularly, the present invention pertains to the fabrication of electrical connections associated with thermal detecting structures.

A thermal detecting structure can be generally defined as a very sensitive thermometer that is used in the detection and measurement of thermal radiation. For example, a thermal detecting structure may be used to detect IR radiation, and therefore, operate as an IR sensor. Fabrication of a thermal detecting structure generally includes providing a thermal detecting material.

The thermal detecting material desirably includes a measurable property that varies with detected thermal radiation. For example, the resistance of the material may vary as a function of detected thermal radiation. A goal in the design of thermal detecting structures is to maximize the sensitivity of the thermal measurements. One factor in the sensitivity of resistance-based thermal detecting structures is a property of the thermal detecting material called thermal coefficient of resistance (TCR) (often expressed in % change in resistance per °C). For example, the thermal detecting material may be selected to provide the highest TCR that is compatible with the other materials and processes used in the fabrication of the thermal detecting structures.

One example of a thermal detecting structure is a two-level infrared thermal detecting array as described in U.S. Patent No. Re. 36,136, entitled "Thermal Sensor," issued to Higashi et al. on 9 March 1999. This thermal detecting structure includes a detector structure with integrated circuitry on a silicon substrate beneath the detector structure. The use of the two-level structure may, for example, provide the ability to form more detectors in a particular area.

Another example of a previous thermal detecting structure is a two-level infrared thermal detecting array as described in U.S. Patent No. 6,144,285, entitled "Thermal Sensor and Method of Making Same," issued to Higashi on 7 November 2000. this thermal detecting structure includes an upper detector section that includes a temperature responsive detector of a vanadium oxide having a high TCR above a lower section that includes integrated circuits. The upper detector section is supported above the lower section by leg portions of the vanadium oxide. The leg portions may be electrically connected both to the detector of the upper section and to the integrated circuits of the lower section. In other words, the vanadium oxide used to form the detector also provides electrical connection therefrom to the integrated circuits of the lower section eliminating the need for using other interconnect materials to make such connections. As described herein, a back sputtering process is used to reduce the sheet resistance of the vanadium oxide that forms the interconnects.

US-A-6,130,109 relates to a method of forming a microbridge thermal detecting structure having a multilayered microsupport which has a lower end connected to the substrate layer and an upper end connected to the microstructure.

A publication entitled "Improved VO₂ microbolometers for infrared imaging: operation on the semiconducting-metallic phase transition with negative electrothermal feedback" of Reinstema C D et al, Proc. Spie - Int. - Eng. (USA), proceedings of the Spie - International Society of Optical Engineering, 1999, Spie-Int. Soc. Opt. Eng, USA, vol. 3698, April 1999, pages 190-200, relates to an ac-biasing method for biasing devices fabricated from crystalline thin films of phase-pure VO₂ patterned into test structures. These test structures include sensors of varying geometry with and without resistive heaters in proximity, antenna-coupled microbolometers for optical response measurements, and Van der Pauw structures for measuring specific contact resistance between VO₂ and Au.

US-A-6,323,486 relates to a method of biasing method devices formed from crystalline thin films of VₓO_{y} patterned into useful structures. These structures include sensors of varying geometry with and without resistive heaters in proximity, antenna-coupled microbolometers for optical response measurements, and Van der Pauw structures for measuring specific contact resistance between VO₂ and Au.

A goal in the design of the electrical connections between the thermal detector and integrated circuitry of the thermal detecting structures below the detector is to lower the electrical resistance of such connections.

### Summary of the Invention

The methods described herein enhance the performance of thermal detecting structures. For example, such processes reduce the resistance of one or more electrical connections. Reducing the resistance of the electrical interconnects provides a reduction in the electrical noise levels which enhances the performance of the thermal detecting structure. For example, lower resistance reduces noise which improves the signal to noise ratio and therefore improves the sensitivity of the thermal detecting structure.

The present method exploits the use of a process to reduce the resistance of thermal detecting material such that a low resistance contact may be formed between the thermal detecting material and a conductive material. Thus, a conductive material may be utilized to form a low-resistance connection between the thermal detecting material and other conductive contacts.

A fabrication method of a thermal detecting structure according to the present invention is disclosed in claim 1. Further preferred embodiments are disclosed in the dependent claims.

Advantages, together with a more complete understanding of the invention, will become apparent and appreciated by referring to the following detailed description and claims taken in conjunction with the accompanying drawings.

### Brief Description of the Drawings

Figure 1 is a schematic diagram of one embodiment of a thermal detecting structure fabricated using a fabrication process according to the present invention.
Figure 2 is one embodiment of a general flow diagram of a fabrication process according to the present invention.
Figure 3 is a perspective view of one embodiment of a thermal detecting structure fabricated using a process such as that shown in Figure 6.
Figure 4 is a cross section of Figure 3 taken along Line 4-4, showing the thermal detecting material including the contact regions.
Figure 5 is a cross section of Figure 3 taken along Line 5-5, showing a portion of the electrical connection including a basket-shaped via.
Figure 6 is one embodiment of the general flow diagram of Figure 2 showing a fabrication process according to the present invention.
Figures 7A-7E illustrate cross-section views of a thermal detecting structure (e.g., such as that shown in Figure 3) during a fabrication process for forming such a structure such as the fabrication process as shown in Figure 6.

### Detailed Description of the Embodiments

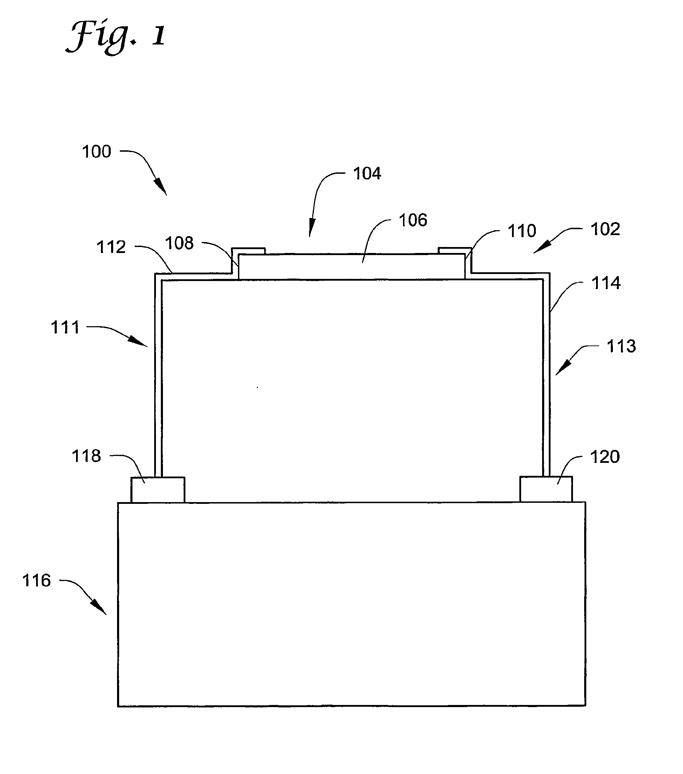

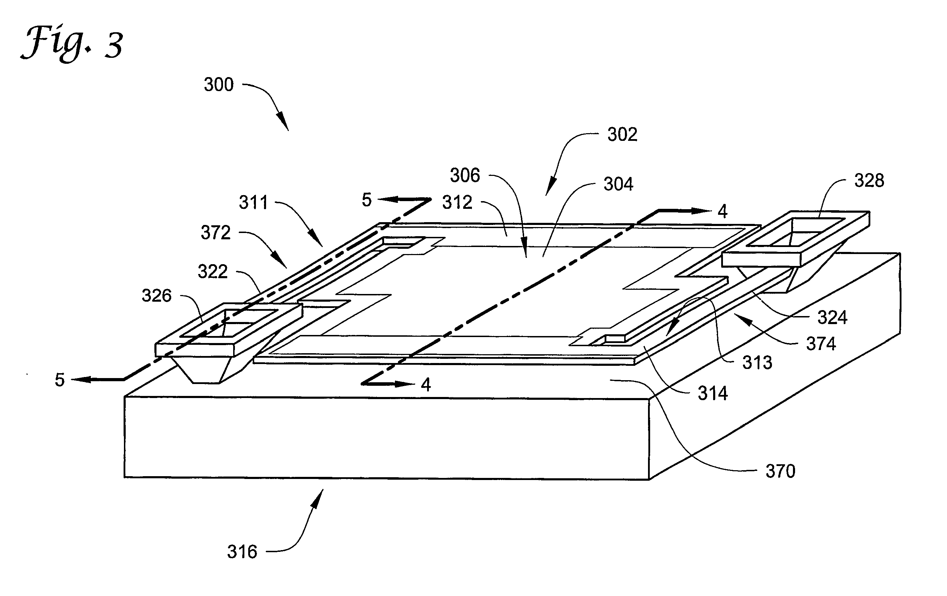

The method of the present invention shall be described generally with reference to Figures 1-2. Thereafter, various other embodiments of the present invention shall be described with reference to Figures 3-7. The present invention provides low resistance connections associated with thermal detecting structures. It should be apparent that the scaling in the figures does not represent precise dimensions of the various elements illustrated therein.

In this application, substrate assembly refers to an assembly upon which additional layers and structures may be fabricated. When reference is made to a substrate assembly in the following description, various process steps may have been previously utilized to form layers, vias, or other structures as known to one skilled in the art.

In this application, via refers to an opening to which conductive material may be added to form a conductive path through the opening, such that the via can be used to form an electrical connection.

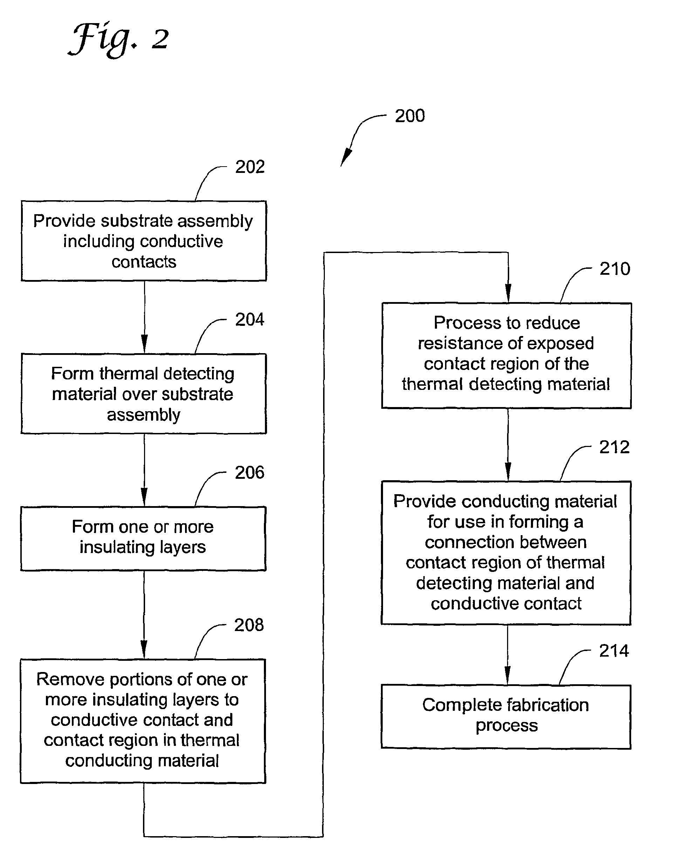

Figure 1 illustrates one general embodiment of a thermal detecting structure 100 that may be fabricated using a method according to the present invention such as generally shown in the embodiment of Figure 2. The thermal detecting structure 100 includes a detector assembly 102 and a substrate assembly 116. The detector assembly 102 includes a thermal detecting material 104 that may be formed relative to the substrate assembly 116. The thermal detecting material 104 includes a temperature responsive detector region 106 and contact regions 108, 110. The substrate assembly 116 includes conductive contacts 118, 120.

Two electrical connections 111, 113 may be formed to electrically connect the thermal detecting material 104 to the conductive contacts 118, 120. Connection 111 may be formed to electrically connect contact region 108 to conductive contact 118 and connection 113 may be formed to electrically connect contact region 110 to conductive contact 120. The connections between the temperature responsive detector region 106 (e.g., thermal detecting material) and conductive contacts 118, 120 may be provided using any number of structures including, but clearly not limited to: portions of the temperature responsive detector region 106; the contact region 108, 110; the conductive material 112, 114; and the conductive contact 118, 120. Other structures that may be used to form the electrical connection include, for example, structures such as vias, basket-shaped vias (see Figure 3, 326, 328), post-shaped vias, openings lined with conductive material, thermal detecting material, or suspended conductive material. For example, structures described in U.S. Patent No. Re. 36,136, Higashi et al. may be used (e.g., a two-level thermal detecting structure in which the connections from the thermal detecting material to the conductive contacts are formed using conductive material).

Figure 2 illustrates one general embodiment of a process flow 200 that may be used to provide a thermal detecting structure such as that shown in Figure 1. However, one skilled in the art will recognize that other thermal detecting structures may be formed thereby. In one or more embodiments, the process flow 200 may be used to fabricate a single thermal detecting structure, or the same process can be used in an example to fabricate multiple thermal detecting structures simultaneously (e.g., fabricate an array of thermal detecting structures on a wafer).

The process flow 200 shown in Figure 2 begins with provision of a substrate assembly 116 (block 202). The fabrication of the substrate assembly 116 may be performed using various techniques known to those skilled in the art. As described previously, a substrate assembly may include a substrate upon which various features and devices using, for example, various layers and structures, may be fabricated. The substrate assembly 116 includes conductive contacts 118, 120. The substrate assembly may include additional structures and devices. For example, the devices and structures that may be formed include, but are not limited to: bipolar transistors; field effect transistors (FET); diodes; pads; lines; planarization layers; sacrificial layers; reflective layers, insulating layers formed from various materials; conductive interconnects; vias; or any integrated circuit structures, any devices, or any other structures known to one skilled in the art. The substrate assembly may be formed from a variety of materials. The substrate may be any structure that is a suitable underlying structure for the method of the present invention. For example, a substrate assembly of a thermal detecting structure is described in U.S. Patent No. Re. 36,136 to Higashi et al.

As further shown in Figure 2, a thermal detecting material 104 may be formed over at least a portion of the substrate assembly 116 (block 204). For example, the thermal detecting material may be deposited over the entire surface and then patterned to form the detector region 106. Formation of such material may be accomplished with any process compatible with the selected thermal detecting material.

The thermal detecting material may be any material that provides the desired thermal characteristics and is compatible with the processes and other materials used. For example, materials that may be used as thermal detecting material include vanadium oxide (VOx), InSb (a semiconductor), FeO (a metal oxide), or NbVO (a metal oxide).

In one embodiment of the present invention, preferably VOx is used as the thermal detecting material. VOx may be characterized by having a high temperature coefficient of resistance (TCR) in the range of about 0.5 %/°C to about 5 %/°C. U.S. Patent No. 6,322,670 entitled "Flexible High Performance Microbolometer Detector Material Fabricated Via Controlled Ion Beam Sputter Deposition Process," issued to Cole et al. on 27 November 2001, and U.S. Patent No. 6,495,070, entitled "Flexible High Performance Microbolometer Detector Material Fabricated Via Controlled Ion Beam Sputter Deposition Process," issued to Cole et al. on 17 December 2002, describe the use of VOx material and a method for providing and using VOx material in a fabrication process.

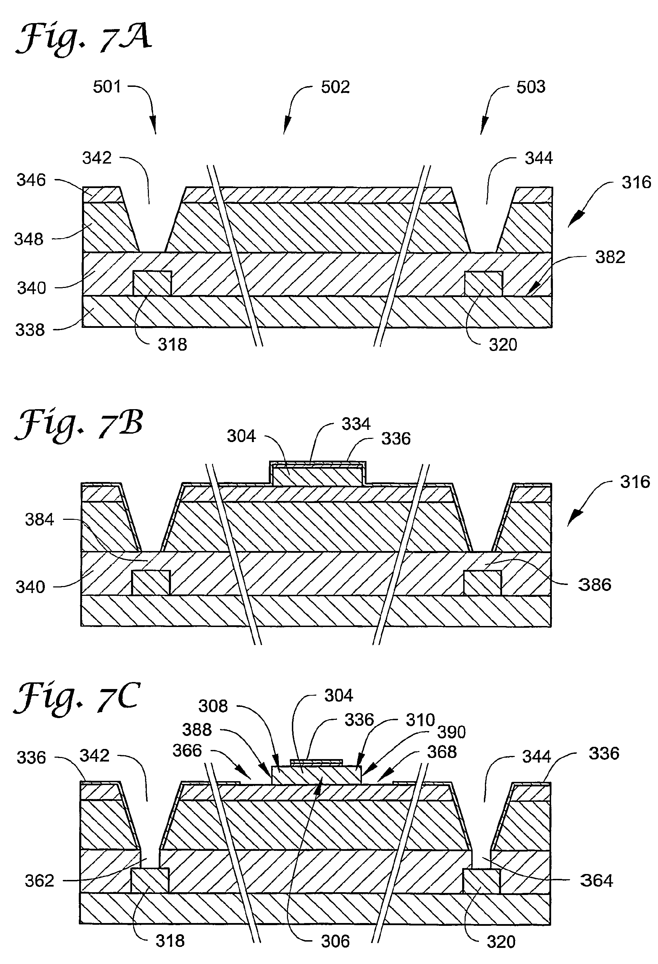

In one embodiment, various layers may be formed prior to forming the thermal detecting layer 104. For example, as shown in Figures 7A and 7B, prior to forming the thermal detecting material 304, a substrate assembly 316 may be formed including an integrated circuit 338 including conductive contacts 318, 320. A planarization layer 340 may be formed over integrated circuit 338. A sacrificial layer 348 may be formed over the planarization layer 340 and an insulating layer 346 may be formed over the sacrificial layer 348. The thermal detecting material 304 may be then formed over insulating layer 346.

Figure 2 further shows forming one or more insulating layers relative to the thermal detecting material (block 206). Such insulating layers may be used during the fabrication process (e.g., insulating layers 334, 336 such as described with respect to the process flow shown in Figures 7B to 7E), and may or may not be present when the fabrication is complete, thus they are not shown in Figure 1. These layers may be used during fabrication, for example, to provide protection for underlying layers or to provide a mask layer for subsequent process steps. In one embodiment of the present invention, there may be at least one insulating layer on the thermal detecting material to provide a mask for use in subsequent process steps. These insulating layers may be formed from a variety of materials and the number of insulating layers may vary.

Various insulating layer materials may be selected for use in the method of the present invention. Generally, such materials are compatible with other process materials and processes used in the fabrication of the thermal detecting structures. For example, such materials may provide one or more of the following functions: mechanical support; patternability; thermal isolation; and electrical isolation. For example, silicon dioxide, silicon oxynitride, or silicon nitride may be used to form insulating layers. These materials provide thermal isolation, electrical isolation, and are generally patternable.

At least portions of the one or more insulating layers may be removed to form openings to conductive contacts 118, 120 (block 208). In addition, portions of the same insulating layers or different insulating layers may be removed to form the contact regions 108, 110 of the thermal detecting material 104. In other words, the insulating layers may be patterned to provide openings for subsequent process steps.

For example, in one embodiment such as shown in Figures 7B and 7C, one or more insulating layers 334, 336 may be patterned such that material may be selectively removed (e.g., by etching) in subsequent steps. Figure 7C shows openings 362, 364 created such that in a subsequent step, conductive material may be formed to provide a connection to the conductive contacts 318, 320. Openings 362, 364 may be created by removing insulating layer 336 from the basket-shaped opening 342, 344 and further, removing a portion 384, 386 of the planarization layer 340, thus exposing conductive contacts 318, 320.

Further, for example, Figure 7C shows openings 366, 368 created such that in a subsequent step, conductive material may be formed to provide a connection to the contact regions 308, 310 of the thermal conducting material 304. Openings 366, 368 may be created by removing one or more insulating layers 334, 336 from the contact region 308, 310 of the thermal conducting material 304 and an area immediately adjacent thereto, thus exposing contact regions 308, 310.

The removal of portions of the one or more insulating layers may be performed by any method known to those in the art. For example, this may be performed by any known methods, such as wet etching (e.g., using a composition that includes, for example, hydrofluoric acid or phosphoric acid) or dry etching (e.g., plasma etching, ion-beam milling, or reactive ion etching). Following the removal of portions of one or more of the insulating layers, the electrical contact regions 108, 110 of thermal detecting material 104 may be exposed for later processing. In addition, the conductive contacts 118, 120 are exposed for later processing.

Following the exposure of the contact regions 108, 110 (i.e., exposure of a surface of the thermal detecting material 104), at least in one embodiment, a process that subjects the exposed contact regions 108, 110 of the thermal detecting material 104 to contact with inert gas ions is performed (block 210). For example, in one embodiment, subjecting the exposed contact regions 108, 110 alters the exposed contact regions 108, 110 such that when the exposed contact regions 108, 110 are later contacted with conductive material to form an electrical connection, the electrical contact between the altered exposed contact region and the conductive material exhibits reduced contact resistance.

In one embodiment of the present invention, this operation may be performed by back sputtering the exposed contact regions 108, 110 of the thermal detecting material 104. Back sputtering may also be referred to as sputter cleaning. Back sputtering may be used to alter, and in one embodiment may remove material from, at least the exposed surface of the thermal detecting material 104.

Back sputtering includes, for example, contacting the exposed surface of the thermal detecting material with inert gas ions thereby altering the exposed surface. In one embodiment, altering the exposed surface includes removing material from the exposed surface. In addition, back sputtering may be performed on a surface that includes a mask or insulating material that provides openings to the surface (i.e., openings that define the exposed surface).

Back sputtering, in one embodiment of the present invention, includes providing a chamber in which the substrate assembly 116 having the thermal detecting material 104 formed thereon may be positioned and contacting at least the exposed surface of the thermal detecting material with inert gas ions (e.g., argon, gas ions).

One factor in the selection of the thermal detecting material to be used is TCR. Preferably, at least in one embodiment, a thermal detecting material with a relatively high TCR is selected, where the TCR is in the range of about 0.5 %/°C to about 5 %/°C. Further, another property of the thermal detecting material is that the material 104 includes both a metal component and a non-metal component (e.g., a metal oxide). In at least one embodiment, the non-metal component is removed faster than the metal component, i.e., the back sputtering rate of the non-metal component is higher than the back sputtering rate of the metal component. In other words, the back sputtering alters the composition of the thermal detecting material.

In one embodiment of the present invention, the thermal detecting material 104 may be vanadium oxide, which may be abbreviated as VOx. In one embodiment, the parameter x is 1.0 or greater. Further, preferably x is 2.5 or less. With x in the range of 1.0 to 2.5, a corresponding range of TCR of about 0.5 %/°C to about 5 %/°C is provided. Vanadium oxide with the range of x previously described provides the desired properties including a relatively high TCR and the back sputtering property described previously. A description of the VOx material and the related deposition process may be found in U.S. Patent No. 6,495,070 to Cole et al.

In one embodiment of the present invention, the back sputtering of the VOx material is performed. Such back sputtering alters the composition of the VOx material by removing more oxygen than vanadium during the process. The portions of the VOx material that are back sputtered (e.g., the exposed contact regions 108, 110) may be later used to form electrical contacts that exhibit reduced contact resistance.

With further reference to Figure 2, conductive material 112, 114 may be provided for use in forming electrical connections 111,113 (block 212). Conductive material 112 may be used to form a connection between the contact region 108 of the thermal detecting material 104 and the conductive contact 118. Similarly, conducting material 114 may be used to form a connection between the contact region 110 of the thermal detecting material 104 and the conductive contact 120. Forming the conductive material 112, 114 may be performed by any method known to those in the art, e.g., chemical vapor deposition, sputtering, etc.

The conductive material 112, 114 selected for use in the method of the present invention is generally compatible with the other materials and processes used in the fabrication of the thermal detecting structures and is a suitable electrical conductor (e.g., a conductive material including at least one of nickel or chromium). Considerations that may be used in selecting the conductive material include one or more of: the property of forming a suitable electrical contact to the thermal detecting material; the property of forming suitable step coverage over large steps; and the property of forming minimum thickness connections (and thereby reducing thermal conductance).

After the electrical connections 111,113 are formed, the remainder of the fabrication process to provide the resultant thermal detecting structure may be performed as generally shown by block 214. Such processing may be accomplished using any methods known to those in the art, and may include, for example: forming additional insulating layers; forming vias; patterning layers; forming conductive structures; probing the wafer; and packaging the thermal detecting structure.

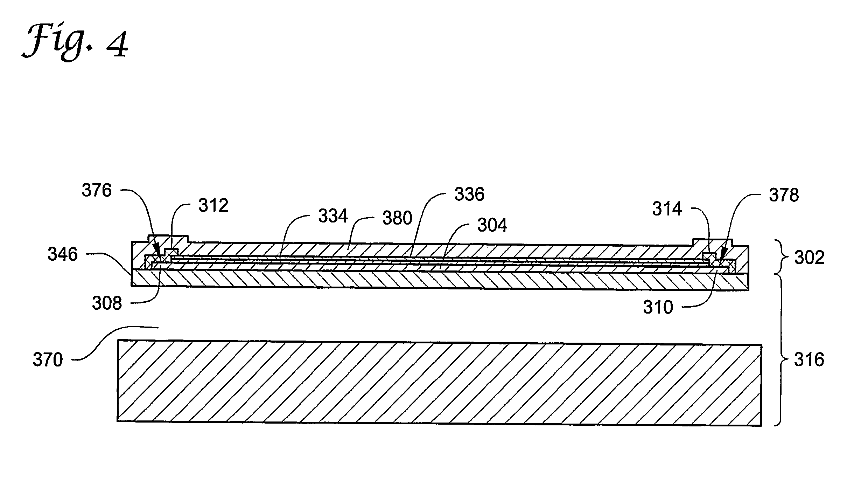

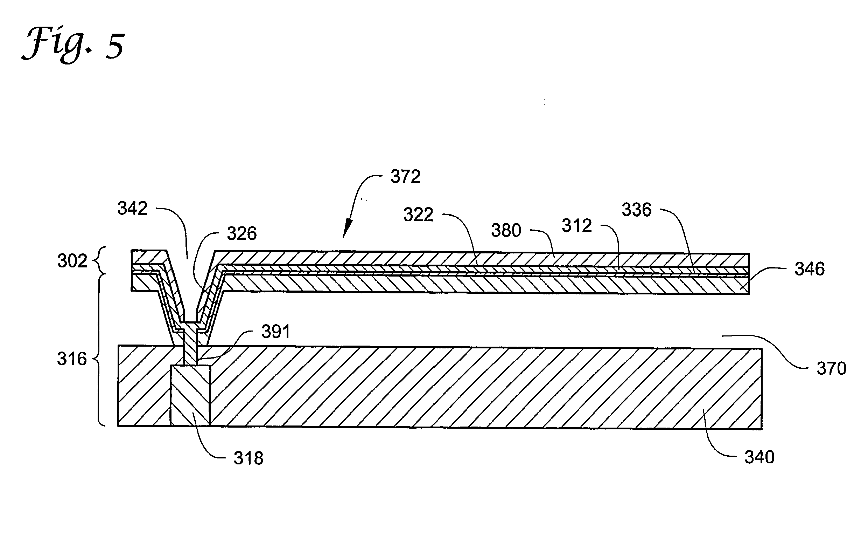

In at least one embodiment of a thermal detecting structure fabricated using the method of the present invention, the thermal detecting structure includes a detector assembly spaced from a portion of the substrate assembly by a gap. In other words, the gap may be between the detector assembly and the substrate assembly, or the gap may be between the detector assembly including some portion of the substrate assembly, and the remaining portion of the substrate assembly (i.e., the gap may be between layers of the substrate assembly). For example, as shown in Figures 4 and 5, the gap 370 is between the detector assembly 302 including some portion of the substrate assembly (i.e., nitride layer 346) and a remaining portion of the substrate assembly.

The gap provides thermal isolation between the detector assembly and a portion of the substrate assembly. For example, the gap may be an air gap. Vias may be used to provide at least a portion of the electrical connections between the detector assembly and the portion of the substrate assembly (i.e., provide electrical connections across the gap), and may also provide structural support. In one embodiment, the vias may be fabricated as basket-shaped vias, and in yet another embodiment of the present invention, the vias may be post-shaped vias.

The method of the present invention may be beneficial in forming any thermal detecting structure, however, for simplicity purposes the remainder of the description below is provided with respect to forming thermal detection structures using VOx material as the thermal detecting material. In addition, the present invention will primarily be described with reference to the formation of thermal detecting structures using VOx material as described with reference to Figures 3-7 along with electrical connections formed to connect contact regions of the VOx material to conductive contacts of an underlying substrate assembly (e.g., contacts to underlying circuitry).

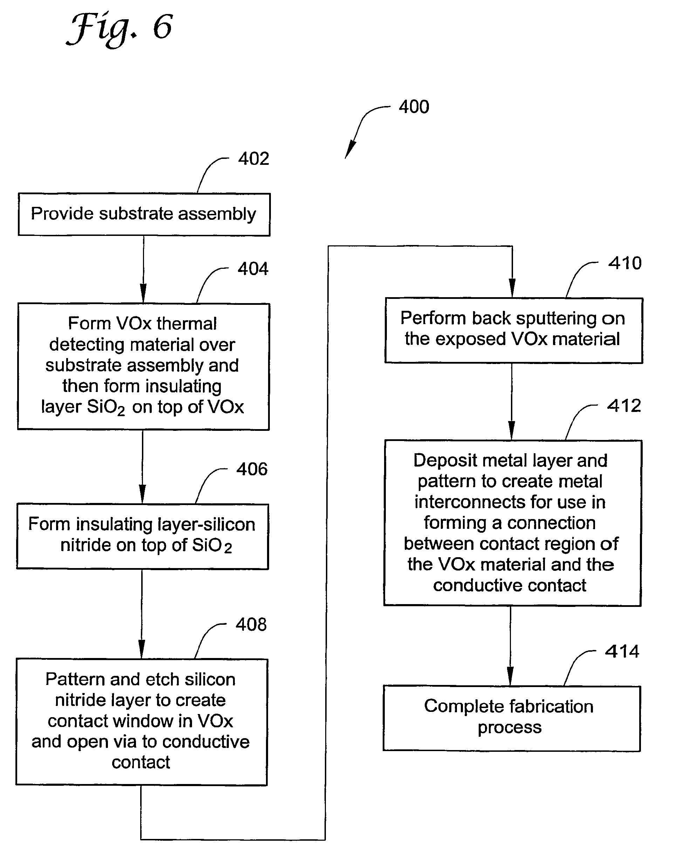

Figure 3 is a perspective view of one embodiment of a thermal detecting structure 300 fabricated using a method according to the present invention such as that described with reference to Figure 6. As can be seen, thermal detecting structure 300 is an example of a detector assembly 302 spaced from a portion of a substrate assembly 316 by a gap 370, as described above. Further, Figure 3 includes basket-shaped vias 326, 328, and leg structures 372, 374 that include conductive legs 322, 324.

The detector assembly 302 of the thermal detecting structure 300 includes the thermal detecting material 304, which includes a temperature responsive detector region 306 and contact regions 308, 310 shown more clearly in Figure 4. Figure 3 also includes electrical connections 311, 313 from the thermal detecting material 304 to the basket-shaped vias 326, 328. The connection 311 includes the electrical contact region 308 of the thermal detecting material 304 and conductive material 312 used to form a conductive leg 322 and a basket-shaped via 326. Similarly, the connection 313 includes the electrical contact region 310 of the thermal detecting material 304 and conductive material 314 used to form a conductive leg 324 and a basket-shaped via 328. Although not visible in Figure 3, the thermal detecting material 304 may be covered with an insulating layer of SiO₂. Also, although not visible in Figure 3, the SiO₂ may be covered with an insulating layer of silicon nitride. The SiO₂ layer 334 and the silicon nitride layer 336 can be seen in the other process diagrams (e.g., Figures 7B-7E).

Figure 4 is one embodiment of a cross section taken at line 4-4 of Figure 3. Figure 4 shows a partial cross section through the center of the thermal detecting structure 300 and includes a view of the detector assembly 302 and a portion of the substrate assembly 316, spaced apart by gap 370. Figure 4 illustrates the electrical contact formed between the exposed surface 376, 378 of contact region 308, 310 and the conductive material 312, 314. The detector assembly 302 includes a thermal detecting material 304, a first insulating layer 334 formed over the thermal detecting material 304, a second insulating layer 336 formed over the first insulating layer 334, a third insulating layer 380 formed over the second insulating layer 336, and conductive material 312, 314 formed to contact the exposed surface of the contact region 308, 310 of the thermal detecting material. The conductive material 312, 314 forms a step over the various layers adjacent the contact region 308, 310, and forms the electrical contact by contacting the exposed surface 376, 378 of the contact region 308, 310 of thermal detecting material 304. The conductive material 312, 314 extends from the thermal detecting material to make contact with the substrate electronics by way of, for example, the vias 326, 328 not shown in Figure 4. Figure 4 includes first insulating layer 334, second insulating layer 336, and third insulating layer 380 which are not shown in Figure 3.

Figure 5 is one embodiment of a cross section taken at line 5-5 of Figure 3. Figure 5 shows a cross section through a leg structure 372 and a basket-shaped via 326, and includes a view of the detector assembly 302 and the substrate assembly 316, spaced apart by gap 370.

Figure 5 illustrates the layering of both the leg structure 372 and the basket-shaped via 326. The leg structure 372 includes the second insulating layer 336 and the conductive leg 322 formed from conductive material 312.

The basket-shaped via 326 may be formed on the substrate assembly 316 such that the various layers conform to the walls of the basket-shaped opening 342 in the substrate assembly 316. The basket-shaped via 326 includes the second insulating layer 336 and the conductive material 312, both formed to the basket-shaped opening. The conductive material 312 may be formed to fill the opening 391 in the planarization layer 340 and to make contact with conductive contact 318, thus forming a conductive path through the via 326 to the conductive contact 318.

Thus, Figure 5 illustrates the conductive leg 322 and basket-shaped via 326 that may be used to form a connection between the thermal detecting material 304 and conductive contact 318. Figure 5 includes third insulating layer 380 that is not shown in Figure 3.

Figure 6 illustrates one embodiment of a process flow 400 of the present invention that may be used to fabricate a single thermal detecting structure using VOx as the thermal detecting material. The process flow 400 may be used to fabricate a single thermal detecting structure, however, the same process can be used to fabricate multiple thermal detecting structures simultaneously (e.g., fabricate an array of thermal detecting structures on a wafer). Figure 6 will be described with further reference to Figures 7A-7E that show cross sections of the thermal detecting structure as the process flow 400 proceeds.

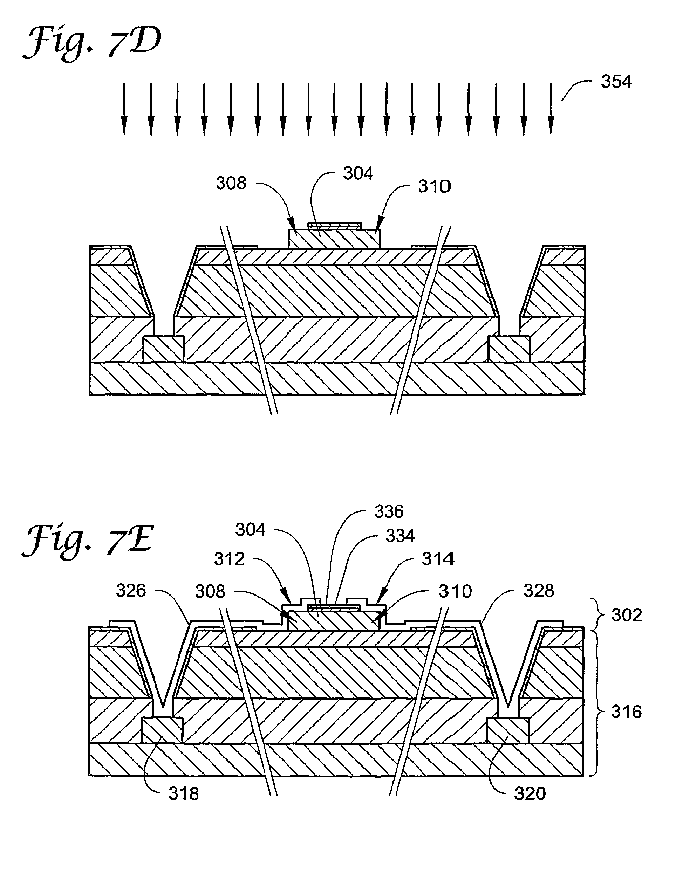

The cross sections shown in Figure 7 are representative of three distinct regions of a thermal detecting structure such as the structure 300 shown in Figure 3. For example, the three regions of each cross section of Figure 7 may be found in Figure 3 (not to scale). In each cross section of Figure 7, the three regions represented (which are separated by break lines in Figure 7) are: a basket-shaped via region 501, with an example shown as including the basket shaped via 326 in Figure 3; a center cross section region 502 including the thermal detecting material, with an example shown as including the thermal detecting material 304 in Figure 3; and a basket-shaped via region 503, with an example shown as including the basket-shaped via 328 in Figure 3.

The process flow 400 as shown in Figure 6 begins with provision of a substrate assembly 316 (block 402). The fabrication of the substrate assembly may be performed using processes and material known to those in the art. One embodiment of a substrate assembly is shown in Figure 7A.

The integrated circuit 338 of the substrate assembly 316 may include any type of integrated circuitry (e.g., electronic circuitry). For example, the integrated circuitry may include electronic circuitry for interfacing and processing the information received from the temperature responsive detector region 306 of the thermal detecting material 304. The integrated circuit 338 includes conductive contacts 318, 320 which may be used to form electrical connections to the thermal detecting material 304 as described further herein.

In one embodiment, the planarization layer 340 may be formed on top of the integrated circuit in order to provide a flat, planar surface for the following fabrication steps. The sacrificial layer 348 may be formed over the planarization layer 340. The sacrificial layer 348 may be included in substrate assembly 316 and remains there during the fabrication process. However, in one embodiment, when fabrication of the thermal detecting structure is substantially complete, the sacrificial layer 348 may be removed to create a gap between the detector assembly 302 and a portion of the substrate assembly 316.

A bottom bridge insulating layer 346 may be formed over the sacrificial layer 348 and provides structural support for all the layers to be formed over it during subsequent processing. Patterning of the insulating layer 346 is used to form the basket-shaped openings 342, 344 in which vias may be formed as described herein.

In one embodiment of the invention, as further shown in Figure 6 (block 404), thermal detecting material, such as VOx material 304, may be formed over at least a portion of the substrate assembly 316, as shown in Figure 7B. Thereafter, a layer of insulating material, such as SiO₂ 334 may be formed over the VOx material 304. The VOx material 304 and SiO₂ 334 may be patterned through the use of, for example, a lift-off process. For example, to perform the lift-off process, a photoresist layer may be formed and patterned to define the areas where the VOx material and SiO₂ may be present. Next, the VOx material may be formed over the photoresist, and then the SiO₂ layer may be formed over the VOx material. Then, the patterning may be performed by removal of the photoresist which also removes the VOx material and SiO₂ on top of the photoresist. The result of the patterning may be a region of VOx material 304 capped with SiO₂ 334.

Although the lift-off process is described above, the formation of the VOx material 304 and SiO₂ 334 may be performed by any process known to one skilled in the art. A process to deposit the VOx material 334 and the SiO₂ 334 is provided in U.S. Patent No. 6,495,070 to Cole et al., which describes a controlled ion beam sputter deposition process which can be used to form VOx material including a range of the parameter x.

An insulating layer such as a silicon nitride layer 336 may be formed over the SiO₂ 334 (block 406). The silicon nitride layer 336 may be formed by any process known to those skilled in the art, for example, chemical vapor deposition.

With further reference to Figure 6, the silicon nitride layer 336 may be patterned to create openings that expose regions of the VOx material 304 (block 408). For example, portions of the silicon nitride layer 336 may be removed to provide openings 366, 368 adjacent to the contact regions 308, 310 of the VOx material 304, as shown in Figure 7C. Further, portions of the silicon nitride layer 336 and a portion of the planarization layer 384, 386 may be removed to provide openings 362, 364 to the conductive contacts 318, 320, as shown in Figures 7B and 7C.

The result of the above processing includes an opening 362, 364 above each conductive contact 318, 320, and as a result, the conductive contacts 318, 320 are exposed for later processing. Suitable patterning and etching techniques known to one skilled in the art may be used to perform these operations. In one embodiment, this removal may be performed using plasma etching.

Further, the openings 366, 368 adjacent the VOx material may be defined by removing the silicon nitride layer 336 from the contact regions 308, 310 of the VOx material 304. These openings 366, 368 provide exposed surfaces 388, 390 of the VOx material 304 where electrical contacts may be formed. As a result, the electrical contact regions 308, 310 of the VOx material 304 may be exposed for later processing. The silicon nitride may be patterned and etched using any process known to those in the art, for example, milling or reactive ion etching may be used. In another embodiment, this etching may be done using plasma etching.

In this embodiment, back sputtering is performed on the exposed VOx material (block 410). Figure 7D illustrates the back sputtering 354 of the exposed contact regions 308, 310 of the VOx material 304. Back sputtering may be performed to alter the exposed contact regions 308, 310 such that in subsequent processing, electrical contacts may be formed with a conductive material that exhibit reduced contact resistance.

In one embodiment, back sputtering may be performed by providing a chamber in which the substrate assembly 316 having the VOx material 304 formed thereon may be positioned and then subjecting the exposed contact regions 308, 310 of the VOx material 304 to contact with inert gas ions (e.g., argon gas ions).

The VOx material 304 includes a metal component, i.e., vanadium, and a non-metal component, i.e., oxygen. Furthermore, preferably the VOx material 304 includes the property that when the VOx material 304 is back sputtered, the oxygen of the VOx material 304 is removed faster than the vanadium component (i.e., the back sputtering rate of the oxygen is higher than the back sputtering rate of the vanadium). In other words, the back sputtering alters the composition of the exposed contact regions 308, 310 of the VOx material 304. The exposed contact regions 308, 310 of the VOx material 304 that are back sputtered may be subsequently used to form electrical contacts with a conductive material that exhibit reduced contact resistance.

In an example, the back sputtering may be performed using a Perkin Elmer 2400 sputtering system at a power of 800 mWatts in 10mTorr of argon for a time period of less than 5 minutes. One skilled in the art will recognize that such parameters are exemplary only and not to be construed as limiting on the present invention. Preferably, less than 20 monolayers of thermal detecting material is removed. More preferably, less than 5 monolayers of the thermal detecting material is removed.

Following the back sputtering, conductive material 312, 314 may be used to form connections between the contact region 308, 310 of the thermal detecting material 304 and the conductive contacts 318, 320 (block 412), as shown in Figure 7E. Conductive material may be deposited over at least a portion of the surface of the detector assembly 302, and may be patterned to form the conductive material 312, 314 used to form the electrical connections. In one embodiment, the conductive material 312, 314 may include nickel and chromium. The nickel-chromium conductive material may be deposited over at least a portion of the surface of the detector assembly 302. Following the deposition, the nickel-chromium conductive material may be patterned to form structures 312 and 314. An electrical connection 311 may be thereby formed between the VOx material 304 and the conductive contact 318. The components of this electrical path are: VOx material 304; the back sputtered contact region of the VOx material 308; the nickel-chromium conductive material 312 contacting the VOx material 308; the nickel-chromium conductive material 312 forming a connection to basket-shaped via 326, the nickel-chromium conductive material 312 forming a basket-shaped via 326; and the basket-shaped via 326 contacting the conductive contact 318. Similarly, an electrical connection 313 may be formed between the VOx material 304 and the conductive contact 320.

The deposition of the conductive material and the patterning of the conductive material may be done by any process known to one skilled in the art. For example, deposition processes include chemical vapor or physical vapor deposition processes.

The method of the present invention forms, structures that provide low-resistance connections (e.g., connections 311, 313 in Figure 3). The back sputtering of the contact regions 308,310 of the VOx material 304 provides for low contact resistance between the VOx material 304 and the conductive material 312, 314 (e.g., nickel-chromium conductive material). Because the present invention provides for reduced contact resistance between the VOx material 304 and the conductive material 312, 314, the present invention can also provide for the remainder of the connection between the VOx material 304 and the conductive contact 318, 320 to be formed using the conductive material 312, 314 (which provides reduced resistance as compared to the same-connection formed using just the VOx material as described in U.S. Patent 6,144,285).

Although various conductive materials may be used, such as, for example, copper, aluminum, nickel, gold, and chromium, in one embodiment, preferably nickel-chromium conductive material is used that includes a ratio by weight of about 80% nickel and 20% chromium. In addition, in one embodiment, the preferred thickness of the nickel-chromium conducive material is in the range of about 1000 angstroms.

Following the deposition and patterning of the conductive material, the fabrication of the thermal detecting structure may be completed, as shown in Figure 6 (block 414). The completion of the fabrication may include, but is not limited to, for example: forming additional insulating layers; forming vias; patterning layers; forming conductive structures; wafer probing; and packaging. These completion operations may be performed using any methods known to one skilled in the art.

This invention has been described with reference to illustrative embodiments and is not meant to be construed in a limiting sense.

## Claims

1. A fabrication method of a thermal detecting structure, the method comprising:
providing a substrate assembly (116, 316) comprising a plurality of conductive contacts (118, 120, 318, 320);
forming a thermal detecting material (104, 304) on at least a portion of the substrate assembly; said thermal detecting material having a detector region (106, 306);
forming a leg structure (372, 374) between said detector region of said thermal detecting material (104, 304) and at least one of said plurality of conductive contacts (118, 120, 318, 320)
forming an electrical connection (311, 313) between said thermal detecting material and at least one of the plurality of conductive contacts (118,120,318,320); and
forming an insulating layer (334, 336) over at least a portion of the thermal detecting material and said substrate assembly;
removing a portion of said insulating layer (334, 336) formed over at least a portion of said thermal detecting material and said substrate assembly to define a contact region (308, 310) comprising an exposed surface of the thermal detecting material between said detector region (306) and said leg structure (372, 374),
subjecting the exposed surface of the contact region of the thermal detecting material to inert gas ions to alter the exposed surface;
**characterized in that**:
forming an electrical connection (311, 313) between said thermal detecting material and at least one of the plurality of conductive contacts comprises
forming a single layer of conductive material (112, 114, 312, 314) connecting the altered exposed surface of the thermal detecting material of the contact region (308, 310) to at least one of the plurality of conductive contacts (118, 120,318,320);
and **in that** said leg structure (372, 374) includes said insulating layer (334, 336) and a conductive leg (322, 324) formed from said single layer of conductive material.

2. The method of claim 1, further comprising removing a portion of said insulating layer (334, 336) further to expose the at least one plurality of conductive contacts (118, 120, 318, 320).

3. The method according to claim 1 or 2, wherein subjecting at least the exposed surface of thermal detecting material (104, 304) of the contact region (108, 110, 308, 310) to inert gas ions to alter the exposed surface comprises back sputtering at least the exposed surface of thermal detecting material.

4. The method according to claim 3, wherein back sputtering at least the exposed surface of thermal detecting material (104, 304) comprises: providing a chamber in which the substrate assembly (116, 316) having the thermal detecting material formed thereon is positioned; and subjecting at least the exposed surface of thermal detecting material to contact with the inert gas ions.

5. The method according to claim 4, wherein subjecting at least the exposed surface of thermal detecting material (104, 304) of the contact region to the inert gas ions further comprises biasing the substrate assembly (116, 316).

6. The method according to any one of the preceding claims, wherein the inert gas ions comprise argon ions.

7. The method according to any one of the preceding claims, wherein the thermal detecting material (104, 304) comprises a metal component and a non-metal component.

8. The method according to claim 7, wherein the non-metal component is removed faster than the metal component when subjected to contact with inert gas ions.

9. The method according to any one of the preceding claims, wherein the thermal detecting material (104, 304) comprises vanadium oxide (VOx).

10. The method according to claim 9, wherein x is in the range of 1.0 to 2.5.

11. The method according to any one of the preceding claims, wherein the conductive material (112, 114, 312, 314) comprises at least one of nickel, copper, aluminum, gold, and chromium.

12. The method according to any one of the preceding claims, wherein the conductive material (112, 114, 312, 314) comprises nickel and chromium.

13. The method according to any one of the preceding claims, wherein the thermal detecting structure comprises a detector assembly spaced from a portion of the substrate assembly by a gap.

14. The method according to claim 13, wherein forming said electrical connection between said thermal detecting material (104,304) and said at least one of the plurality of conductive contacts (118, 120, 318, 320) further comprises providing a via (326, 328) formed from said single layer of conductive material;
said via (326, 328) being integrated with said conductive leg (322, 324) and contacting said at least one of said plurality of conductive contacts (118, 120, 318, 320).

15. The method according to claim 14, wherein providing the via (326, 328) comprises providing a basket-shaped via.

16. The method according to claim 14, wherein providing the via (326, 328) comprises providing a post-shaped via.

## Patentansprüche

1. Fabrikationsverfahren einer wärmedetektierenden Struktur, wobei das Verfahren folgendes umfaßt:
Bereitstellen einer Substratanordnung (116, 316), die mehrere leitende Kontakte (118, 120, 318, 320) umfaßt;
Ausbilden eines wärmedetektierenden Materials (104, 304) auf mindestens einem Abschnitt der Substratanordnung, wobei das wärmedetektierende Material ein Detektorgebiet (106, 306) aufweist;
Ausbilden einer Schenkelstruktur (372, 374) zwischen dem Detektorgebiet des wärmedetektierenden Materials (104, 304) und mindestens einem der mehreren leitenden Kontakte (118, 120, 318, 320);
Ausbilden einer elektrischen Verbindung (311, 313) zwischen dem wärmedetektierenden Material und mindestens einem der mehreren leitenden Kontakte (118, 120, 318, 320) und
Ausbilden einer Isolierschicht (334, 336) über mindestens einen Abschnitt des wärmedetektierenden Materials und der Substratanordnung;
Entfernen eines Teils der über mindestens einem Abschnitt des wärmedetektierenden Materials und der Substratanordnung ausgebildeten Isolierschicht (334, 336) zum Definieren eines Kontaktgebiets (308, 310), umfassend eine exponierte Oberfläche des wärmedetektierenden Materials zwischen dem Detektorgebiet (306) und der Schenkelstruktur (372, 374),
Aussetzen der exponierten Oberfläche des Kontaktgebiets des wärmedetektierenden Materials Inertgasionen, um die exponierte Oberfläche zu verändern;
**dadurch gekennzeichnet, daß:**
das Ausbilden einer elektrischen Verbindung (311, 313) zwischen dem wärmedetektierenden Material und mindestens einem der mehreren leitenden Kontakte folgendes umfaßt:
Ausbilden einer einzelnen Schicht aus leitendem Material (112, 114, 312, 314), die die veränderte exponierte Oberfläche des wärmedetektierenden Materials des Kontaktgebiets (308, 310) mit mindestens einem der mehreren leitenden Kontakte (118, 120, 318, 320) verbindet;
und daß die Schenkelstruktur (372, 374) die Isolierschicht (334, 336) und einen leitenden Schenkel (322, 324), aus der einzelnen Schicht aus leitendem Material ausgebildet, enthält.

2. Verfahren nach Anspruch 1, weiterhin umfassend das Entfernen eines Abschnitts der Isolierschicht (334, 336), um den mindestens einen der mehreren leitenden Kontakte (118, 120, 318, 320) weiter zu exponieren.

3. Verfahren nach Anspruch 1 oder 2, wobei das Aussetzen mindestens der exponierten Oberfläche des wärmedetektierenden Materials (104, 304) des Kontaktgebiets (108, 110, 308, 310) Inertgasionen zum Ändern der exponierten Oberfläche das Rücksputtern mindestens der exponierten Oberfläche des wärmedetektierenden Materials umfaßt.

4. Verfahren nach Anspruch 3, wobei das Rücksputtern mindestens der exponierten Oberfläche des wärmedetektierenden Materials (104, 304) folgendes umfaßt: Bereitstellen einer Kammer, in der die Substratanordnung (116, 316) mit dem darauf ausgebildeten wärmedetektierenden Material positioniert wird, und Aussetzen mindestens der exponierten Oberfläche des wärmedetektierenden Materials einem Kontakt mit den Inertgasionen.

5. Verfahren nach Anspruch 4, wobei das Aussetzen mindestens der exponierten Oberfläche des wärmedetektierenden Materials (104, 304) des Kontaktgebiets Inertgasionen weiterhin das Vorspannen der Substratanordnung (116, 316) umfaßt.

6. Verfahren nach einem der vorhergehenden Ansprüche, wobei die Inertgasionen Argonionen umfassen.

7. Verfahren nach einem der vorhergehenden Ansprüche, wobei das wärmedetektierende Material (104, 304) eine Metallkomponente und eine Nicht-Metallkomponente umfaßt.

8. Verfahren nach Anspruch 7, wobei die Nicht-Metallkomponente schneller entfernt wird als die Metallkomponente, wenn sie einem Kontakt mit Inertgasionen ausgesetzt wird.

9. Verfahren nach einem der vorhergehenden Ansprüche, wobei das wärmedetektierende Material (104, 304) Vanadiumoxid (VOx) umfaßt.

10. Verfahren nach Anspruch 9, wobei x im Bereich von 1,0 bis 2,5 liegt.

11. Verfahren nach einem der vorhergehenden Ansprüche, wobei das leitende Material (112, 114, 312, 314) mindestens Nickel, Kupfer, Aluminium, Gold und/oder Chrom umfaßt.

12. Verfahren nach einem der vorhergehenden Ansprüche, wobei das leitende Material (112, 114, 312, 314) Nickel und Chrom umfaßt.

13. Verfahren nach einem der vorhergehenden Ansprüche, wobei die wärmedetektierende Struktur eine Detektoranordnung umfaßt, die durch einen Spalt von einem Abschnitt der Substratanordnung beabstandet ist.

14. Verfahren nach Anspruch 13, wobei das Ausbilden der elektrischen Verbindung zwischen dem wärmedetektierenden Material (104, 304) und mindestens einem der mehreren leitenden Kontakte (118, 120, 318, 320) weiterhin das Bereitstellen eines aus der einzelnen Schicht aus leitendem Material ausgebildeten Durchkontakts (326, 328) umfaßt;
wobei der Durchkontakt (326, 328) mit dem leitenden Schenkel (322, 324) integriert ist und den mindestens einen der mehreren leitenden Kontakte (118, 120, 318, 320) kontaktiert.

15. Verfahren nach Anspruch 14, wobei das Bereitstellen des Durchkontakts (326, 328) das Bereitstellen eines korbförmigen Durchkontakts umfaßt.

16. Verfahren nach Anspruch 14, wobei das Bereitstellen des Durchkontakts (326, 328) das Bereitstellen eines pfostenförmigen Durchkontakts umfaßt.

## Revendications

1. Procédé de fabrication d'une structure de détection thermique, le procédé comprenant :
l'obtention d'un ensemble substrat (116, 316) comprenant une pluralité de contacts conducteurs (118, 120, 318, 320) ;
la formation d'un matériau de détection thermique (104, 304) sur au moins une partie de l'ensemble substrat, ledit matériau de détection thermique comportant une région détectrice (106, 306) ;
la formation d'une structure de patte (372, 374) entre ladite région détectrice dudit matériau de détection thermique (104, 304) et l'un au moins de ladite pluralité de contacts conducteurs (118, 120, 318, 320) ;
la formation d'une connexion électrique (311, 313) entre ledit matériau de détection thermique et l'un au moins de ladite pluralité de contacts conducteurs (118, 120, 318, 320) ;
la formation d'une couche isolante (334, 336) par-dessus au moins une partie du matériau de détection thermique et dudit ensemble substrat ;
le retrait d'une partie de ladite couche isolante (334, 336) formée par-dessus au moins une partie dudit matériau de détection thermique et dudit ensemble substrat pour définir une région de contact (308, 310) comprenant une surface exposée du matériau de détection thermique entre ladite région détectrice (306) et ladite structure de patte (372, 374) ; et
la soumission de la surface exposée de la région de contact du matériau de détection thermique à des ions de gaz inerte pour modifier la surface exposée ;
**caractérisé en ce que :**
la formation d'une connexion électrique (311, 313) entre ledit matériau de détection thermique et l'un au moins de la pluralité de contacts conducteurs comprend
la formation d'une monocouche de matériau conducteur (112, 114, 312, 314) reliant la surface exposée modifiée du matériau de détection thermique de la région de contact (308, 310) à l'un au moins de la pluralité de contacts conducteurs (118, 120, 318, 320) ;
et **en ce que** :
ladite structure de patte (372, 374) comprend ladite couche isolante (334, 336) et une patte conductrice (322, 324) formée à partir de ladite monocouche de matériau conducteur.

2. Procédé selon la revendication 1, comprenant en outre le retrait d'une partie de ladite couche isolante (334, 336) pour exposer davantage l'au moins une pluralité de contacts conducteurs (118, 120, 318, 320).

3. Procédé selon la revendication 1 ou 2, dans lequel la soumission au moins de la surface exposée du matériau de détection thermique (104, 304) de la région de contact (108, 110, 308, 310) à des ions de gaz inerte pour modifier la surface exposée comprend le décapage ionique au moins de la surface exposée du matériau de détection thermique.

4. Procédé selon la revendication 3, dans lequel le décapage ionique au moins de la surface exposée du matériau de détection thermique (104, 304) comprend : l'obtention d'une chambre dans laquelle est positionné l'ensemble substrat (116, 316) avec le matériau de détection thermique formé par-dessus ; et la soumission au moins de la surface exposée de matériau de détection thermique à un contact avec les ions de gaz inerte.

5. Procédé selon la revendication 4, dans lequel la soumission au moins de la surface exposée du matériau de détection thermique (104, 304) de la région de contact aux ions de gaz inerte comprend en outre la polarisation de l'ensemble substrat (116, 316).

6. Procédé selon l'une quelconque des revendications précédentes, dans lequel les ions de gaz inerte comprennent des ions argon.

7. Procédé selon l'une quelconque des revendications précédentes, dans lequel le matériau de détection thermique (104, 304) comprend un composant métallique et un composant non métallique.

8. Procédé selon la revendication 7, dans lequel le composant non métallique est retiré plus vite que le composant métallique lorsque soumis à un contact avec des ions de gaz inerte.

9. Procédé selon l'une quelconque des revendications précédentes, dans lequel le matériau de détection thermique (104, 304) comprend de l'oxyde de vanadium (VOx).

10. Procédé selon la revendication 9, dans lequel x se situe dans la gamme de 1,0 à 2,5.

11. Procédé selon l'une quelconque des revendications précédentes, dans lequel le matériau conducteur (112, 114, 312, 314) comprend l'un au moins du nickel, du cuivre, de l'aluminium, de l'or et du chrome.

12. Procédé selon l'une quelconque des revendications précédentes, dans lequel le matériau conducteur (112, 114, 312, 314) comprend du nickel et du chrome.

13. Procédé selon l'une quelconque des revendications précédentes, dans lequel la structure de détection thermique comprend un ensemble détecteur espacé d'une partie de l'ensemble substrat par un interstice.

14. Procédé selon la revendication 13, dans lequel la formation de ladite connexion électrique entre ledit matériau de détection thermique (104, 304) et ledit au moins un de la pluralité de contacts conducteurs (118, 120, 318, 320) comprend en outre l'obtention d'un trou d'interconnexion (326, 328) formé à partir de ladite monocouche de matériau conducteur ;
ledit trou d'interconnexion (326, 328) étant intégré à ladite patte conductrice (322, 324) et en contact avec ledit au moins un de ladite pluralité de contacts conducteurs (118, 120, 318, 320).

15. Procédé selon la revendication 14, dans lequel l'obtention du trou d'interconnexion (326, 328) comprend l'obtention d'un trou d'interconnexion en forme de panier.

16. Procédé selon la revendication 14, dans lequel l'obtention du trou d'interconnexion (326, 328) comprend l'obtention d'un trou d'interconnexion en forme de montant.
